# EUROPÄISCHE PATENTSCHRIFT

(11) **EP 4 286 630 B1**
(45) Veröffentlichungstag und Bekanntmachung des Hinweises auf die Patenterteilung: **24.06.2026**
(21) Anmeldenummer: 23173966.5
(22) Anmeldetag: 17.05.2023
(51) Int. Cl.: E05B 81/76, H01H 13/12

(54) **BETÄTIGUNGSMODUL FÜR EIN ELEKTRONISCHES SCHLIESSSYSTEM UND FAHRZEUGKOMPONENTE**
ACTUATING MODULE FOR AN ELECTRONIC LOCKING SYSTEM AND VEHICLE COMPONENT
MODULE D'ACTIONNEMENT POUR UN SYSTÈME DE FERMETURE ÉLECTRONIQUE ET COMPOSANT DE VÉHICULE

(30) Priorität: 03.06.2022 DE 102022205722
(43) Veröffentlichungstag der Anmeldung: 06.12.2023
(73) Patentinhaber: Witte Automotive GmbH, 42551 Velbert (DE)
(72) Erfinder: MENSCH, Reinaldo, 42113 Wuppertal (DE); HÖHN, Ralf, 42549 Velbert (DE)
(74) Vertreter: Liedtke & Partner Patentanwälte

(56) Entgegenhaltungen:
- EP-A1- 3 734 002
- DE-A1- 102014 107 809
- US-A1- 2019 017 302
- US-A1- 2021 108 450

## Beschreibung

Die Erfindung betrifft ein Betätigungsmodul für ein elektronisches Schließsystem, insbesondere zum Entriegeln, Verriegeln, Öffnen und/oder Schließen des elektronischen Schließsystems, insbesondere eines elektronischen Schlosses eines beweglichen Fahrzeugelements, insbesondere einer Fahrzeugtür. Des Weiteren betrifft die Erfindung eine Fahrzeugkomponente mit einem solchen Betätigungsmodul.

Beispielsweise sind aus dem Stand der Technik Griffmodule an Fahrzeugtüren, Heckklappen oder Motorhauben bekannt. Diese sind üblicherweise mit einem Griffelement versehen, das nach außen geschwenkt werden kann, um die Fahrzeugtür, die Heckklappe oder die Motorhaube öffnen zu können. Griffmodule können dabei elektronische Sensormodule zum Öffnen oder Schließen eines Schlosses der Tür umfassen.

Zum Beispiel ist aus der US 2021/108450 A1 eine Türgriffanordnung bekannt, die dazu bestimmt ist, an einer Tür eines Kraftfahrzeugs montiert zu werden, wobei die Türgriffanordnung einen Griff, eine Betätigungsvorrichtung und eine erste Steuervorrichtung zum Öffnen der Tür umfasst, wobei die Steuervorrichtung in den Griff integriert ist und mit einem elektrischen Entriegelungssystem verbunden ist.

Der Erfindung liegt die Aufgabe zu Grunde, ein gegenüber dem Stand der Technik verbessertes Betätigungsmodul sowie eine Fahrzeugkomponente, beispielsweise ein Griffmodul, ein Zierelement und/oder eine Fahrzeugsäule, mit einem solchen Betätigungsmodul anzugeben.

Die erstgenannte Aufgabe wird erfindungsgemäß durch ein Betätigungsmodul mit den Merkmalen des Anspruchs 1 gelöst. Die zweitgenannte Aufgabe wird erfindungsgemäß durch eine Fahrzeugkomponente mit den Merkmalen des Anspruchs 8 gelöst.

Die Aufgabe wird erfindungsgemäß gelöst mit einem Betätigungsmodul für ein elektronisches Schließsystem, wobei das Betätigungsmodul zumindest eine Betätigungseinheit und einen im Innenraum der Betätigungseinheit angeordneten, beispielsweise kapazitiven, Betätigungssensor zum Ausführen beziehungsweise Auslösen einer Schaltfunktion, zum Beispiel zum Entriegeln und Öffnen des elektronischen Schließsystems, umfasst, wobei die Betätigungseinheit zumindest eine in eine Außenumgebung gerichtete Betätigungsfläche und ein nach innen gerichtetes Betätigungselement umfasst, das bewegungsfest mit der Betätigungsfläche verbunden ist, wobei die Betätigungsfläche elastisch verformbar ist und bei einer Betätigung der Betätigungsfläche in Richtung des Betätigungssensors das Betätigungselement einen Betätigungshub ausübt, wobei der Betätigungssensor eingerichtet ist, einen Betätigungshub zumindest in einem Mikrometer-Bereich zu erfassen und ein Auslösesignal zur Auslösung der Schaltfunktion zu erzeugen.

Mit anderen Worten: Die Betätigungsfläche ist bei Betätigung derart elastisch verformbar, dass die Betätigungsfläche und somit das Betätigungselement in Richtung des innenliegenden Betätigungssensors in zumindest einem Mikrometer-Bereich (später auch als µm-Bereich fortgeführt) zur Auslösung der Schaltfunktion bewegbar ist. Beispielsweise kann das erfindungsgemäße Betätigungsmodul bereits einen Betätigungshub von weniger als 10 µm erfassen.

Das Betätigungsmodul ist kompakt und bauraumsparend ausgebildet und kann in einfacher Weise in bereits vorhandene Fahrzeugteile integriert werden. Die mit der Erfindung erzielten Vorteile bestehen darin, dass das Betätigungsmodul unterhalb von Oberflächen bereits vorhandener oder neu herzustellender Fahrzeugteile, von Fahrzeugkomponenten, beispielsweise von so genannten Class-A-Teilen, von Emblemen, von Zierelementen, von Betätigungselementen, beispielsweise Türaußengriffen oder Türinnengriffen, und von B-Säulen und C-Säulen eines Fahrzeugs in einfacher Weise integrierbar ist. Das Betätigungsmodul ist hochauflösend ausgebildet und kann eine Betätigung, beispielsweise ein Drücken, bereits in zumindest einem µm-Bereich erfassen. Diese Handhabung kommt beispielsweise unterschiedlichen Altersgruppen und/oder Nutzern mit Behinderungen zu Gute. Eine sichere beziehungsweise zuverlässige Betätigung, insbesondere sichere Auslösung einer Schaltfunktion, kann bereits bei kleinstem Kraftaufwand und/oder kleinster Kontaktierung der Betätigungsfläche stattfinden. Bei einem Fahrbetrieb des Fahrzeugs können die Schaltfunktionen und/oder Auslösungsfunktionen deaktiviert sein.

Das erfindungsgemäße Betätigungsmodul ist derart ausgebildet, dass keine Notwendigkeit besteht, einen mechanischen Betätigungshub beziehungsweise mechanischen Betätigungsweg generieren zu müssen. Dies kann durch eine punktuelle elastische Verformung oder Deformation der Betätigungsfläche umgesetzt werden. Eine mit dem erfindungsgemäßen Betätigungsmodul versehene Fahrzeugkomponente kann zusätzlich optisch aufgewertet werden.

In einer Weiterbildung umfasst der Betätigungssensor zumindest ein im Innenraum der Betätigungseinheit fest angeordnetes Sensorelement und ein relativ zum Sensorelement bewegliches Auslöseelement. Durch Bewegung der Betätigungsfläche kann beispielsweise das Auslöseelement des Betätigungssensors mitbewegt werden. Das Auslöseelement ist beispielsweise ein elastisch verformbares Blech, beispielsweise ein Federblech oder Metallblech, insbesondere ein sogenanntes MOC-Blech (MOC = "metal-over-cap"). Insbesondere ist eine Verformung oder Deformation und/oder eine Abstandsänderung zwischen dem Auslöseelement und dem festen Sensorelement des Betätigungssensors bereits in einem µm-Bereich erfassbar.

Das Auslöseelement kann zwischen dem Sensorelement des Betätigungssensors und der Betätigungsfläche gehalten sein. Das Auslöseelement kann beabstandet zum festen Sensorelement und beabstandet zur Betätigungsfläche gehalten sein. Das Auslöseelement kann zumindest bereichsweise elastisch verformbar oder deformierbar ausgebildet sein. Das Auslöseelement kann zumindest bereichsweise flexibel ausgebildet sein.

Die Betätigungsfläche ist beispielsweise mit einem als Betätigungsstift oder Betätigungspin ausgebildeten Betätigungselement versehen. Das Betätigungselement kann als Betätigungsstößel, eine an der Betätigungsfläche ausgebildete Erhebung oder Nase ausgebildet sein. Bei Betätigung der Betätigungsfläche übt das Betätigungselement den Betätigungshub in Richtung des Auslöseelements des Betätigungssensors aus.

Die Betätigungsfläche ist insbesondere innenseitig mit dem Betätigungselement versehen, welches bei Betätigung der Betätigungsfläche mitbewegbar ist und zumindest punktuell in Eingriff mit dem Auslöseelement des Betätigungssensors gelangt und dieses flächig verformt, insbesondere biegt.

In einer Weiterbildung ist das Betätigungselement aus einem Material mit einer höheren Festigkeit als das der Betätigungsfläche ausgebildet. Die Betätigungsfläche ist elastisch verformbar und/oder flexibel ausgebildet. Das Betätigungselement ist eine Festkomponente, beispielsweise ein fester Betätigungsstößel oder Betätigungspin. Das Auslöseelement ist ebenfalls elastisch verformbar und/oder flexibel ausgebildet. Das Betätigungselement weist eine höhere Festigkeit als die des Auslöseelements und die der Betätigungsfläche auf. Eine punktuell oder flächig auf die Betätigungsfläche wirkende Betätigung kann mittels des festen Betätigungselements in einen punktuell auf das Auslöseelement wirkenden Betätigungshub umgesetzt werden, wobei das Auslöseelement flächig oder punktuell verformbar, insbesondere biegbar, ist.

In einer Weiterbildung ist das Auslöseelement mit einem aus Kunststoff gebildeten Abdeckelement versehen. Das Abdeckelement kann zumindest bereichsweise elastisch verformbar oder deformierbar ausgebildet sein. Das Abdeckelement kann zumindest bereichsweise flexibel ausgebildet sein. Bei Betätigung der Betätigungsfläche kann das Betätigungselement einen Betätigungshub auf das Abdeckelement und das Auslöseelement ausüben. Das Auslöseelement kann auf einer dem Betätigungselement zugewandten Seite mit einem Kunststoff und/oder mit einem aus Kunststoff ausgebildeten Abdeckelement beschichtet sein. Die Kunststoffschicht und/oder das Abdeckelement ist zur Abschirmung des Auslöseelements vor einem Vergussmaterial im Innenraum der Betätigungseinheit vorgesehen. Mit anderen Worten: Die Kunststoffschicht beziehungsweise Kunststoffbeschichtung und/oder das Abdeckelement schützen/schützt das Auslöseelement, insbesondere das Auslöseblech, vor einem Vergussmaterial.

Das Betätigungsmodul umfasst eine elektronische Auswerteeinheit, welche mit dem Betätigungssensor verbunden ist, wobei mittels der elektronischen Auswerteeinheit anhand einer erfassten Kapazitätsveränderung des Betätigungssensors eine Betätigungsdeformation oder Betätigungsverformung, beispielsweise ein Deformationsweg oder Verformungsweg, insbesondere den Betätigungshub der Betätigungseinheit ermittelbar ist, wobei der Betätigungssensor und die Auswerteeinheit derart eingerichtet sind, dass bei einer ermittelten Betätigungsdeformation oder Betätigungsverformung, beispielsweise Deformationsweg oder Verformungsweg, insbesondere einem Betätigungshub der Betätigungsfläche und somit des Betätigungselements, von wenigen Mikrometern (µm) ein Auslösesignal zum Ausführen der Schaltfunktion generierbar ist.

Mit anderen Worten: Das Betätigungsmodul umfasst im Innenraum der Betätigungseinheit zumindest eine mit dem Betätigungssensor zumindest signaltechnisch verbundene Auswerteeinheit, welche eingerichtet ist, in Abhängigkeit erfasster Signale des Betätigungssensors ein Schaltsignal für die Schaltfunktion auszulösen. Die Auswerteeinheit ist ausgebildet, bei einem erfassten Betätigungshub des Betätigungselements auf das Auslöseelement und/oder bei einer erfassen Kapazitätsänderung des Betätigungssensors durch Verformung des Auslöseelements in Richtung des festen Sensorelements des Betätigungssensors ein Schaltsignal zu generieren und auszulösen.

Erfindungsgemäß weist die Auswerteeinheit zumindest einen hochauflösenden Analog-Digital-Wandler auf, der mit dem Betätigungssensor zumindest signaltechnisch verbunden ist und eingerichtet ist, einen Betätigungshub des Betätigungssensors in einem Mikrometer-Bereich zu erfassen.

Insbesondere sind der kapazitive Betätigungssensor und die elektronische Auswerteeinheit derart eingerichtet, dass eine minimale reversible Betätigungsdeformation oder reversible Betätigungsverformung im µm-Bereich, beispielsweise weniger als 10 µm, erfassbar ist.

Beispielsweise werden Messwerte für die Kapazitätsveränderung mit einer solchen Auflösung erfasst und mittels der Auswerteeinheit verarbeitet, dass eine reversible Betätigungsdeformation oder reversible Betätigungsverformung der Betätigungseinheit, insbesondere der Betätigungsfläche, von maximal 10 µm oder kleiner erfassbar ist.

Die hier beschriebene Lösung benötigt nur noch einen Betätigungshub, insbesondere reversible Betätigungsdeformation oder Betätigungsverformung, von nur wenigen Mikrometern, beispielsweise von weniger als 10 µm. Dies kann durch die elastische Verformung von Kunststoffteilen der Betätigungseinheit umgesetzt werden. Damit ergibt sich nicht mehr die Notwendigkeit, eine Mechanik und/oder eine Umlenkung vorzusehen, welche einen Weg beispielsweise von größer 1 mm generiert.

Die mit der Erfindung erzielten Vorteile bestehen insbesondere darin, dass das Betätigungsmodul einen sehr geringen Bauraum bedarf. Dadurch lassen sich unterschiedliche Fahrzeugoberflächen (beispielsweise so genannten Class-A-Oberflächen) und/oder eine Fahrzeugaußenhaut mit einem solchen Betätigungsmodul mit einem verbesserten Erscheinungsbild und/oder verbesserter Haptik versehen. Auch können Türgriffe, Embleme, andere Fahrzeugkomponenten, Betätigungsanordnungen und/oder Abdeckungen von A-Säulen und/oder B-Säulen eines Fahrzeugs mit einem solchen Betätigungsmodul ausgestattet werden.

Das Betätigungsmodul kann in einer Weiterbildung auch einen induktiven Betätigungssensor ("conductive touch") aufweisen.

Die erfindungsgemäße Fahrzeugkomponente umfasst zumindest ein Betätigungsmodul nach vorheriger Beschreibung, wobei die Fahrzeugkomponente eine Tür, eine Heckklappe oder ein Griffmodul oder eine Fahrzeugsäule ist.

Ausführungsbeispiele der Erfindung werden anhand von Zeichnungen näher erläutert. Dabei zeigen:
- Figur 1: schematisch in perspektivischer Darstellung ein Fahrzeug mit einem außenseitig angeordneten Betätigungsmodul,
- Figur 2: schematisch in perspektivischer Vorderansicht einen Türaußengriff,
- Figur 3: schematisch in perspektivischer Hinteransicht den Türaußengriff nach Fig. 2,
- Figur 4: schematisch in Vorderansicht eine Betätigungseinheit eines Betätigungsmoduls mit von außen betätigbaren Betätigungsflächen,
- Figur 5: schematisch in Hinteransicht die Betätigungseinheit nach Fig. 4,
- Figur 6: schematisch in Vorderansicht ein Betätigungsmodul für ein elektronisches Schließsystem,
- Figur 7: schematisch in Seitenansicht das Betätigungsmodul nach Fig. 6,
- Figur 8: schematisch in Untersicht das Betätigungsmodul nach Fig. 6,
- Figur 9: schematisch in Schnittdarstellung ein Betätigungsmodul,
- Figur 10: schematisch in Schnittdarstellung ein weiteres Betätigungsmodul für ein elektronisches Schließsystem,
- Figur 11: schematisch in Schnittdarstellung einen Betätigungssensor eines Betätigungsmoduls für ein elektronisches Schließsystem, und
- Figur 12: schematisch ein Blockschaltbild zu einer Funktionsweise des Betätigungsmoduls.

Einander entsprechende Teile sind in allen Figuren mit den gleichen Bezugszeichen versehen.

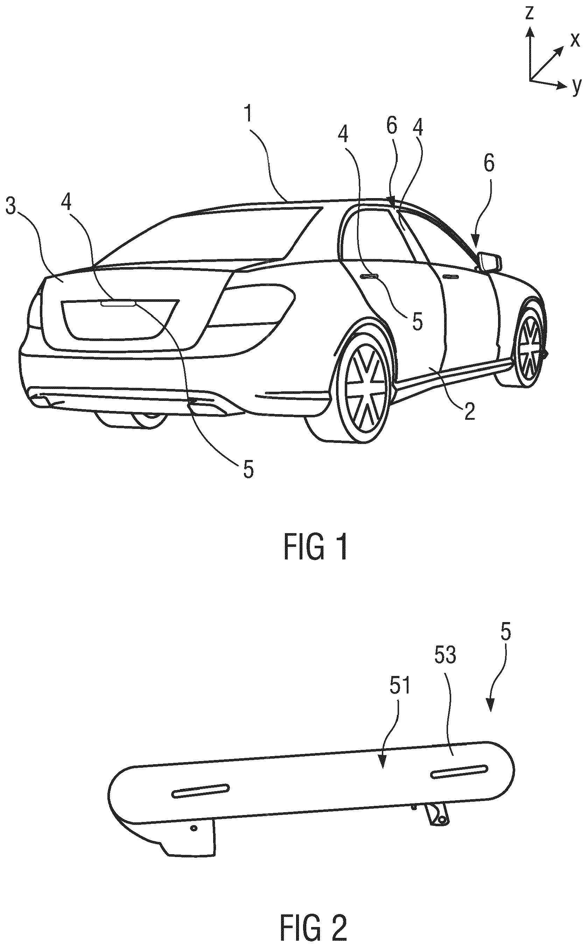

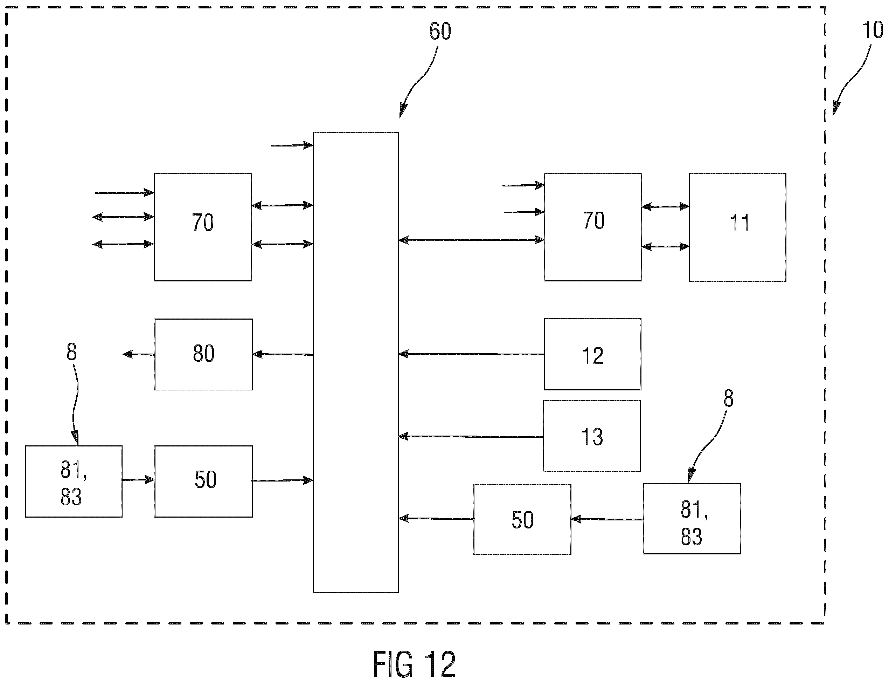

Figur 1 zeigt schematisch ein Fahrzeug 1. Das Fahrzeug 1 weist auf seiner Außenseite mehrere elektronisch schaltbare Bereiche auf. Beispielsweise weist das Fahrzeug 1 im Bereich einer Tür 2 und/oder einer Heckklappe 3 ein Betätigungsmodul 4 für ein elektronisches Schließsystem 80, wie in Figur 12 dargestellt, insbesondere zum Entriegeln, Verriegeln, Öffnen und/oder Schließen des elektronischen Schließsystems 80, insbesondere eines elektronischen Schlosses, der Tür 2 und/oder der Heckklappe 3 auf. Insbesondere dient das Betätigungsmodul 4 dem Erfassen mindestens einer manuellen Betätigung durch eine Hand eines Nutzers. Zur verbesserten Übersicht ist ein Koordinatensystem gezeigt, aufweisend eine Längsachse X, eine Querachse Y und eine Hochachse Z.

Das Betätigungsmodul 4 kann in einem Griffmodul 5 der Tür 2 oder der Heckklappe 3 oder einer Fahrzeugsäule 6, beispielsweise A-Säule und/oder B-Säule des Fahrzeugs 1, angeordnet sein.

Das Betätigungsmodul 4 ermöglicht in einfacher Art und Weise das Aktivieren einer entsprechenden Funktion des Fahrzeugs 1, wie beispielsweise Öffnen oder Schließen der Tür 2, Entriegeln oder Verriegeln eines Heckklappenschlosses oder Frontklappenschlosses, Öffnen oder Schließen der Heckklappe 3. Hierzu kann das Fahrzeug 1 mit mehreren Betätigungsmodulen 4 ausgestattet sein.

Figur 2 zeigt schematisch in perspektivischer Vorderansicht ein Griffmodul 5, insbesondere einen Türaußengriff 51. Das Griffmodul 5 kann beispielsweise eine in eine Außenumgebung gerichtete erste Oberfläche 53 aufweisen. Die erste Oberfläche 53 kann zumindest bereichsweise aus einem elastisch verformbaren und/oder flexiblen Kunststoff gebildet sein.

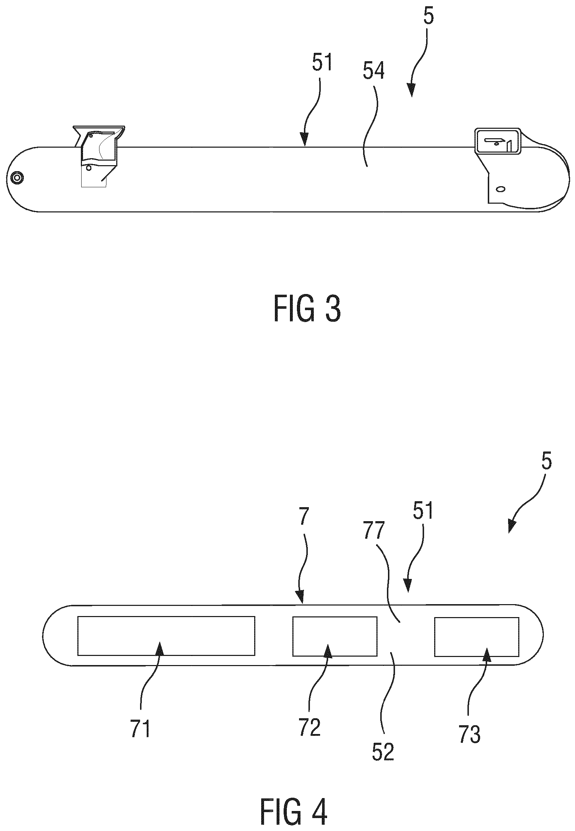

Figur 3 zeigt schematisch in perspektivischer Hinteransicht den Türaußengriff 51 nach Figur 2. In einem solchen Türaußengriff 51 werden diverse Sensoriken integriert. Solche Türaußengriffe 51 sollen möglichst schmal beziehungsweise dünn und kompakt zur optischen Aufwertung einer Fahrzeugaußenseite und einfach zu bedienen ausgebildet sein. Das Griffmodul 5 kann beispielsweise eine in eine Außenumgebung gerichtete zweite Oberfläche 54 aufweisen. Die zweite Oberfläche 54 kann zumindest bereichsweise aus einem elastisch verformbaren und/oder flexiblen Kunststoff gebildet sein.

Figur 4 zeigt schematisch in Vorderansicht eine Betätigungseinheit 7 des Betätigungsmoduls 4 zur Auslösung von Schaltfunktionen, zum Beispiel zum Entriegeln und Öffnen oder Verriegeln und Schließen des elektronischen Schließsystems 80, des Fahrzeugs 1. Die hier dargestellte Betätigungseinheit 7 ist beispielsweise in einer Türgriffabdeckung 52 mit von außen betätigbaren Betätigungsflächen 71 bis 73 integriert oder eingebettet. In einer Weiterbildung kann die Betätigungseinheit 7 eine Abdeckung, beispielsweise eine Türgriffabdeckung 52 oder eine Fahrzeugaußenabdeckung, mit integrierten Betätigungsflächen 71 bis 73 ausbilden. Die Betätigungseinheit 7 kann beispielsweise eine in eine Außenumgebung gerichtete Oberfläche 77 aufweisen. Die Oberfläche 77 kann zumindest bereichsweise aus einem elastisch verformbaren und/oder flexiblen Kunststoff gebildet sein. Beispielsweise sind die Betätigungsflächen 71 bis 73 zumindest aus einem elastisch verformbaren und/oder flexiblen Kunststoff gebildet.

Die Türgriffabdeckung 52 und/oder Betätigungseinheit 7 ist beispielsweise ein Kunststoffteil. Die Betätigungseinheit 7 ist elastisch verformbar ausgebildet. Beispielsweise kann die Türgriffabdeckung 52 zumindest in einem die Betätigungseinheit 7 aufweisenden Bereich elastisch verformbar ausgebildet sein. Die Türgriffabdeckung 52 kann in einer Weiterbildung die Betätigungseinheit 7 oder umgekehrt, die Betätigungseinheit 7 eine Türgriffabdeckung 52 bilden. Auch kann die Türgriffabdeckung 52 vollständig elastisch verformbar ausgebildet sein.

Die Betätigungsflächen 71 bis 73 können als betätigbare Sensorflächen ausgebildet sein. Beispielsweise sind die Sensorflächen durch mehrere Elektroden, beispielsweise Flächenelektroden, Hauptelektroden und Hilfselektroden, gebildet.

Die Betätigungsflächen 71 bis 73 können farblich markiert und/oder mit einem Muster, einem Schriftzug oder einem Bild versehen sein.

Die Türgriffabdeckung 52 und/oder Betätigungseinheit 7 umfassen/umfasst eine erste Betätigungsfläche 71. Die erste Betätigungsfläche 71 umfasst beispielsweise eine NFC-Kommunikationsschnittstelle, über welche beispielsweise eine Schaltfunktion und/oder Kommunikation des Fahrzeugs 1 drahtlos aktivierbar ist.

Die Türgriffabdeckung 52 und/oder Betätigungseinheit 7 umfassen/umfasst eine zweite Betätigungsfläche 72. Die zweite Betätigungsfläche 72 ist beispielsweise ausgebildet, eine Betätigung einer Türschaltfunktion, insbesondere einer Türentriegelungsfunktion und/oder Türöffnungsfunktion, von einem Nutzer zu erfassen. Die zweite Betätigungsfläche 72 ist elastisch verformbar ausgebildet. Der Nutzer kann die Betätigungsfläche 72 um wenige Mikrometer bewegen. Der Nutzer kann bereits mit wenig Druck die Schaltfunktion, insbesondere Türschaltfunktion, aktivieren.

Die Türgriffabdeckung 52 und/oder Betätigungseinheit 7 umfassen/umfasst eine dritte Betätigungsfläche 73. Die dritte Betätigungsfläche 73 ist beispielsweise ausgebildet, eine Betätigung einer weiteren Türschaltfunktion, insbesondere einer Türverriegelungsfunktion und/oder Türschließfunktion, von einem Nutzer zu erfassen.

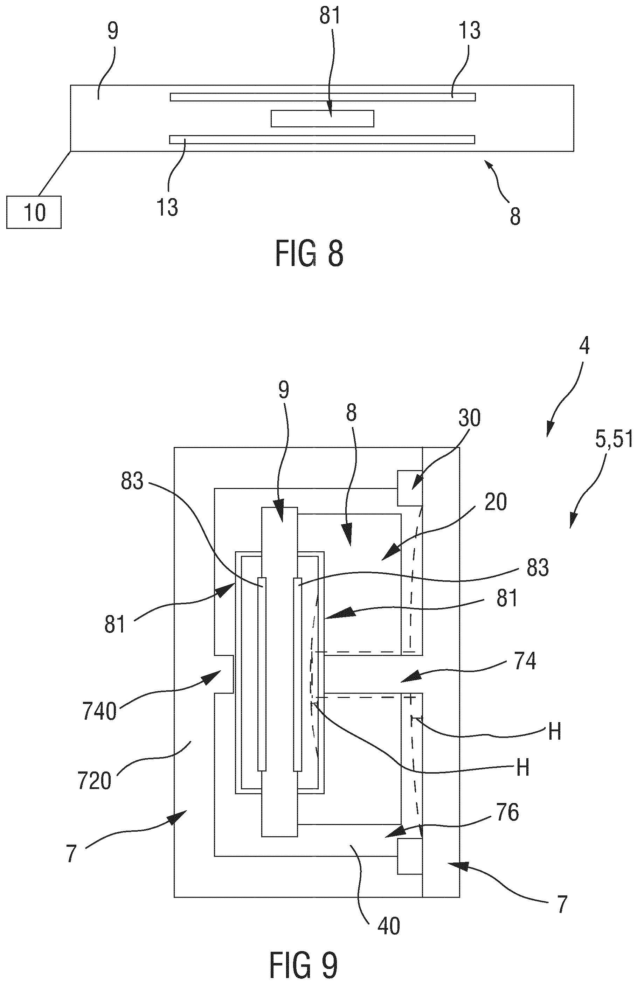

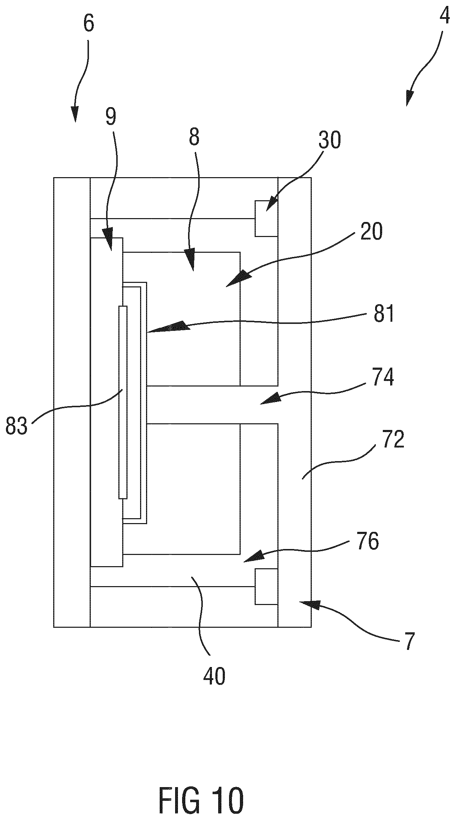

Die Betätigungseinheit 7 umfasst zum Beispiel zumindest ein mit der zweiten Betätigungsfläche 72 verbundenes Betätigungselement 74, wie in Figuren 9 und 10 dargestellt. Das Betätigungselement 74 ist beispielsweise in Form eines Pins, einer Nase, einer Erhebung oder eines Stifts ausgebildet. Die Betätigungsfläche 72 ist beim Betätigen in Richtung eines innen liegenden Betätigungssensors 8, wie in Figuren 9 und 10 dargestellt, und/oder einer Sensoranordnung derart elastisch verformbar, dass das Betätigungselement 74 in einem µm-Bereich zur Auslösung der Schaltfunktion bewegbar ist. Das Betätigungselement 74 kann in einer Weiterbildung deformierbar ausgebildet sein.

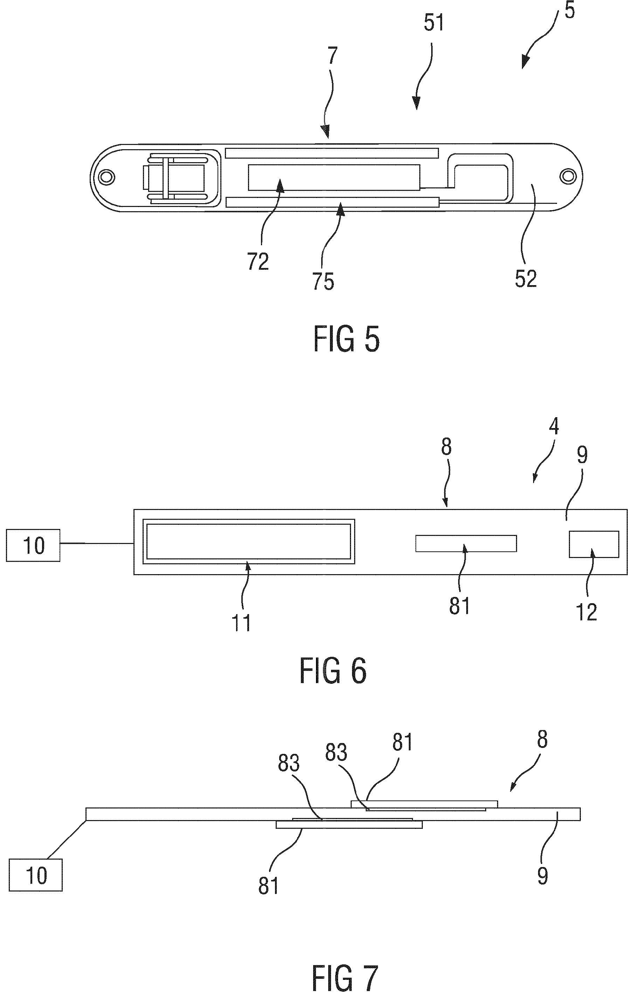

Figur 5 zeigt schematisch in Hinteransicht die Türgriffabdeckung 52 und die Betätigungseinheit 7 nach Figur 4.

Im Bereich der zweiten Betätigungsfläche 72 sind beispielsweise zwei Erfassungssensoren 75 angeordnet. Mittels der Erfassungssensoren 75 kann eine Annäherung des Nutzers, insbesondere einer Hand und/oder von Fingern des Nutzers, erfasst werden. In Abhängigkeit eines Erfassungssignals der Erfassungssensoren 75 kann ein durch die zweite Betätigungsfläche 72 auslösbares Betätigungssignal oder Auslösesignal generiert werden, beispielsweise zur Entriegelung und optional zusätzlich zur Öffnung des Schließsystems 80.

Die Betätigungseinheit 7 ist eine Komponente des Betätigungsmoduls 4.

Figur 6 zeigt schematisch in Vorderansicht ein Betätigungsmodul 4 für ein elektronisches Schließsystem 80 ohne Gehäuse und/oder Abdeckung.

Das Betätigungsmodul 4 umfasst zumindest eine Leiterplatte 9. In Abhängigkeit einer möglichen oder alternativen Ausbildung des Betätigungssensors 8 kann ein erstes nicht näher dargestelltes Sensorelement mit der Leiterplatte 9 eine Messelektrode bilden und ein zweites nicht näher dargestelltes Sensorelement bildet eine Gegenelektrode oder umgekehrt.

Der Betätigungssensor 8 umfasst im dargestellten Ausführungsbeispiel zumindest ein bewegliches, beispielsweise zumindest bereichsweise flexibles, Auslöseelement 81. Der Betätigungssensor 8 umfasst ein auf der Leiterplatte 9 fest angeordnetes Sensorelement 83, wie in Figuren 7, 9 und 10 dargestellt. Das Auslöseelement 81 ist relativ zum festen Sensorelement 83 beweglich ausgebildet. Das Auslöseelement 81 ist beispielsweise U-förmig ausgebildet. Das Auslöseelement 81 kann endseitig jeweils an der Leiterplatte 9 befestigt und zum festen Sensorelement 83 beabstandet angeordnet sein. Das auf der Leiterplatte 9 angeordnete feste Sensorelement 83 und/oder die Erfassungssensoren 75 können/kann jeweils eine feste Elektrode ausbilden. Das Auslöseelement 81 bildet eine zur festen Elektrode bewegliche Gegenelektrode.

Das Auslöseelement 81 ist ein sogenanntes MOC-Blech. Beispielsweise ist das Auslöseelement 81 ein Metallblech oder ein aus Metall gebildetes Federelement.

Das Betätigungsmodul 4 umfasst eine Auswerteeinheit 10, die beispielsweise Teil einer Sensorelektronik des Betätigungsmoduls 4 ist. Mittels der insbesondere elektronischen Auswerteeinheit 10 ist eine Kapazitätsänderung des kapazitiven Betätigungssensors 8 ermittelbar. Die Kapazitätsänderung wird anhand einer Abstandsverringerung zwischen dem Auslöseelement 81 und dem festen Sensorelement 83 und/oder der Erfassungssensoren 75 ermittelt. Das Sensorelement 83 und/oder die Erfassungssensoren 75 sind beispielsweise kapazitive Sensoren, welche eine Abstandsänderung zwischen diesen und dem Auslöseelement 81 anhand einer Kapazitätsänderung erfassen. Das Auslöseelement 81 ist dabei von der Betätigungseinheit 7 bewegbar. Mittels der Auswerteeinheit 10 ist bereits eine Abstandsänderung und/oder Bewegung in einem µm-Bereich erfassbar. Das Betätigungselement 74 ist beispielsweise mit dem Auslöseelement 81 in Kontakt oder unmittelbar an diesem angeordnet.

Des Weiteren sind auf der Leiterplatte 9 beispielsweise eine Antenne 11 und eine Verriegelungssensorfläche 12 angeordnet, die den entsprechenden Betätigungsflächen 71 und 73 zugeordnet sind.

Figur 7 zeigt schematisch in Seitenansicht das Betätigungsmodul 4 nach Figur 6. Beispielsweise ist die Leiterplatte 9 beidseitig mit jeweils einem festen Sensorelement 83 und einem relativ zu dem entsprechenden Sensorelement 83 beweglich angeordneten, insbesondere elastisch verformbar ausgebildeten, Auslöseelement 81 bestückt. Ein erstes Auslöseelement 81 dient beispielsweise einem Auslösen der Schließsystementriegelungsfunktion. Ein zweites Auslöseelement 81 dient beispielsweise einem Auslösen der Schließsystemöffnungsfunktion.

Figur 8 zeigt schematisch in Untersicht das Betätigungsmodul 4 nach Figur 6. Die Leiterplatte 9 ist beispielsweise mit Entriegelungssensorflächen 13 bestückt, die beispielsweise den Erfassungssensoren 75 zugeordnet sind. Zwischen diesen ist eines der Auslöseelemente 81 angeordnet.

Figur 9 zeigt schematisch in Schnittdarstellung ein Betätigungsmodul 4 für ein elektronisches Schließsystem 80. Das Betätigungsmodul 4 nach Figur 9 ist beispielsweise ein Türaußengriff 51 mit beidseitig des Türaußengriffs 51 betätigbaren Schaltfunktionen.

Das Betätigungsmodul 4 umfasst im dargestellten Ausführungsbeispiel zwei Betätigungseinheiten 7, beispielsweise je eine Betätigungseinheit 7 auf einer Vorderseite und einer Rückseite eines Griffmoduls 5. Beispielsweise bildet eine der Betätigungseinheiten 7 die Vorderseite und die andere der Betätigungseinheiten 7 die Rückseite eines Griffmoduls 5. Die Betätigungseinheiten 7 schließen zwischen sich einen Innenraum 76 ein.

Das Betätigungsmodul 4 umfasst zwei in einem Innenraum 76 der Betätigungseinheiten 7 angeordnete Betätigungssensoren 8 zur Auslösung zumindest einer Schaltfunktion des Fahrzeugs 1. Die Betätigungseinheiten 7 weisen jeweils eine Anzahl von in eine Außenumgebung gerichtete Betätigungsflächen 71 bis 73, 720 und jeweils ein nach innen gerichtetes Betätigungselement 74, 740 auf. Das jeweilige Betätigungselement 74, 740 ist mit einer ihm zugeordneten Betätigungsfläche 71 bis 73, 720 bewegungsfest verbunden.

Die Betätigungsflächen 71 bis 73, 720 sind zumindest bereichsweise elastisch verformbar und/oder flexibel ausgebildet. Bei einer Betätigung der jeweiligen Betätigungsfläche 71 bis 73, 720 in Richtung des zugeordneten Betätigungssensors 8 übt das entsprechende Betätigungselement 74, 740 einen Betätigungshub H aus.

Der jeweilige Betätigungssensor 8 ist eingerichtet, einen Betätigungshub H zumindest in einem Mikrometer-Bereich zu erfassen und ein Auslösesignal zur Auslösung einer zugeordneten Schaltfunktion zu erzeugen.

Die jeweilige Betätigungsfläche 71 bis 73, 720 ist innenseitig mit dem Betätigungselement 74, 740 versehen, welches bei Betätigung der Betätigungsfläche 71 bis 73, 720 derart mitbewegbar ist, dass das Betätigungselement 74, 740 punktuell in Eingriff mit dem zugehörigen Auslöseelement 81 des entsprechenden Betätigungssensors 8 gelangt und dieses zumindest bereichsweise flächig verformt, insbesondere biegt.

Im Innenraum 76 der Betätigungseinheiten 7 ist eine Auswerteeinheit 10 vorgesehen, die mit den Betätigungssensoren 8 zumindest signaltechnisch verbunden ist. Die Auswerteeinheit 10 ist eingerichtet, in Abhängigkeit erfasster Signale der Betätigungssensoren 8 ein Schaltsignal für die Schaltfunktion auszulösen.

Das Betätigungsmodul 4 ist als ein sogenanntes MOC-Modul (= metal-over-cap-Modul) ausgebildet, bei welchem innenliegende elektronische Komponenten 20, beispielsweise Elektroden und/oder andere elektronische Komponenten 20, und der kapazitive Betätigungssensor 8 nach außen hin gekapselt sind.

An einer Innenseite der zweiten Betätigungsfläche 72 ist das Betätigungselement 74 angeordnet. Die Betätigungsfläche 72 und das Betätigungselement 74 sind beispielsweise einteilig ausgebildet.

Weiterhin weist die Betätigungseinheit 7 eine der zweiten Betätigungsfläche 72 gegenüberliegende Betätigungsfläche 720 auf, die beispielsweise eine Rückseite des Türaußengriffs 51 bildet. Die Betätigungsfläche 720 ist ebenfalls mit einem Betätigungselement 740 versehen, welches mit dem rückseitig an der Leiterplatte 9 angeordneten Betätigungssensor 8, insbesondere mit dem rückseitigen Auslöseelement 81, zusammenwirkt.

Die Betätigungsflächen 72, 720 sind jeweils als Türgriffabdeckungen 52 ausgebildet und miteinander verbunden. Beispielsweise sind Betätigungsflächen 72, 720 in einem Verbindungsbereich mittels einer Versiegelung 30 zumindest stoffschlüssig verbunden. Die Betätigungsflächen 72, 720 sind elastisch verformbare Kunststoffteile.

Ein zwischen den Betätigungsflächen 72, 720 eingeschlossener Innenraum 76 ist beispielsweise mit einem Vergussmaterial 40 versehen. Zwischen dem jeweiligen Auslöseelement 81 und der Leiterplatte 9 ist jedoch kein Vergussmaterial 40 vorgesehen. Das jeweilige Auslöseelement 81 ist zur Leiterplatte 9 beabstandet angeordnet. Das jeweilige Auslöseelement 81 ist beispielsweise kastenförmig ausgebildet und schließt einen Abstandsraum zwischen sich und der Leiterplatte 9 ein.

Figur 10 zeigt schematisch in Schnittdarstellung ein weiteres Betätigungsmodul 4 für ein elektronisches Schließsystem 80. Das Betätigungsmodul 4 nach Figur 10 ist beispielsweise in einer Fahrzeugsäule 6 oder in ein Zierelement integriert und einseitig, also von einer Fahrzeugaußenseite, betätigbar.

Das Betätigungsmodul 4 ist als ein sogenanntes MOC-Modul (= metal-over-cap-Modul) ausgebildet, bei welchem innenliegende Sensorkomponenten, beispielsweise Elektroden, und damit der kapazitive Betätigungssensor 8 nach außen hin gekapselt sind.

Die nach außen gerichtete Betätigungsfläche 72 ist beispielsweise eine Säulenabdeckung oder eine Fahrzeugaußenhaut. Die Betätigungsfläche 72 ist elastisch verformbar ausgebildet.

Beispielsweise ist die Betätigungsfläche 72 in einem Verbindungsbereich mit der Fahrzeugsäule 6 mittels einer Versiegelung 30 zumindest stoffschlüssig verbunden. Die Betätigungsfläche 72 ist ein elastisch verformbares Kunststoffteil.

Ein zwischen der Betätigungsfläche 72 eingeschlossener Innenraum 76 ist beispielsweise mit einem Vergussmaterial 40 versehen. Zwischen dem Auslöseelement 81 und der Leiterplatte 9 ist jedoch kein Vergussmaterial 40 vorgesehen. Das Auslöseelement 81 ist zur Leiterplatte 9 beabstandet angeordnet. Das Auslöseelement 81 ist beispielsweise kastenförmig ausgebildet und schließt einen Abstandsraum zwischen sich und der Leiterplatte 9 ein.

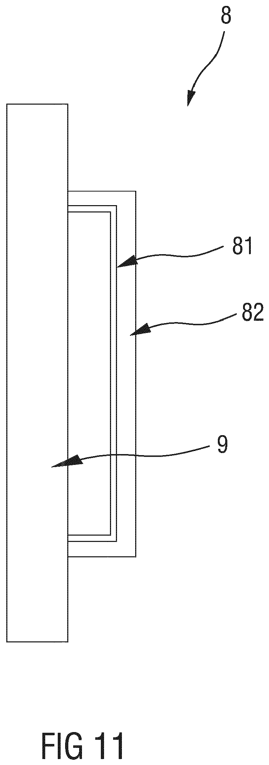

Figur 11 zeigt schematisch in Schnittdarstellung einen Betätigungssensor 8 eines Betätigungsmoduls 4 für ein elektronisches Schließsystem 80. Das jeweilige Auslöseelement 81 des Betätigungssensors 8 kann beispielsweise von einem Abdeckelement 82 umgeben sein. Das Abdeckelement 82 ist beispielsweise eine Kunststoffabdeckung, die das Auslöseelement 81 vor dem Vergussmaterial 40 schützt. Das Abdeckelement 82 ist zur Übertragung einer Betätigungsdeformation der Betätigungseinheit 7 elastisch verformbar ausgebildet.

Figur 12 zeigt schematisch ein Blockschaltbild zu einer Funktionsweise des Betätigungsmoduls 4.

Das Betätigungsmodul 4 umfasst eine Auswerteeinheit 10, die beispielsweise Teil einer Sensorelektronik des Betätigungsmoduls 4 ist. Mittels der insbesondere elektronischen Auswerteeinheit 10 ist eine Kapazitätsänderung des kapazitiven Betätigungssensors 8 ermittelbar.

Die elektronische Auswerteeinheit 10 umfasst einen Analog-Digital-Wandler 50 und einen Mikroprozessor 60, wobei der Analog-Digital-Wandler 50 zur Umwandlung der erfassten Kapazitätsveränderungen in Digitalwerte und der Mikroprozessor 60 zur Verarbeitung der Digitalwerte und zur Erzeugung des Auslösesignals vorgesehen ist. Durch einen hochauflösenden Analog-Digital-Wandler 50 kann eine zuverlässige Erfassung und Auslösung der Schaltfunktion erzielt werden.

Der Analog-Digital-Wandler 50 ist mit dem Betätigungssensor 8 oder den Betätigungssensoren 8 signaltechnisch verbunden und eingerichtet, einen Betätigungshub H des jeweiligen Betätigungssensors 8 in einem Mikrometer-Bereich zuverlässig zu erfassen.

Beispielsweise ist der Analog-Digital-Wandler 50 als ein 16-Bit-Wandler, ein 24-Bit-Wandler oder 32-Bit-Wandler, insbesondere als ein hochauflösender Wandler, ausgebildet. Hierdurch können geringe Verformungen des Betätigungssensors 8 und daraus resultierend geringe Kapazitätsveränderung und daraus resultierend geringe Betätigungsdeformationen oder Betätigungsverformungen erfasst werden, wobei eine Verformung der Betätigungseinheit 7 von wenigen Mikrometern, beispielsweise von maximal 10 µm oder kleiner, erfasst und somit bereits bei einer erfassten geringen Verformung der Betätigungseinheit 7 ein Auslösesignal erzeugbar ist.

Die Kapazitätsänderung wird anhand einer Abstandsverringerung zwischen dem Auslöseelement 81 und dem festen Sensorelement 83 ausgelöst und ermittelt. Der Betätigungssensor 8 ist beispielsweise ein kapazitiver Sensor, welcher eine Abstandsänderung zwischen dem Sensorelement 83 und dem Auslöseelement 81 durch Erfassung einer Kapazitätsänderung erfassen kann. Das Auslöseelement 81 ist dabei in einem Ausgangszustand von dem Sensorelement 83 beabstandet angeordnet und in einem betätigten Zustand oder ausgelösten Zustand näher zum Sensorelement 83 bewegt, insbesondere deformiert.

Mittels der Auswerteeinheit 10 ist bereits eine Abstandsänderung und/oder Bewegung in einem µm-Bereich erfassbar. Das Betätigungselement 74 ist beispielsweise mit dem Auslöseelement 81 in Kontakt oder unmittelbar an diesem angeordnet. Eine Kapazitätsänderung lässt sich durch eine Abstandsänderung zwischen dem Auslöseelement 81 und dem Sensorelement 83 erfassen.

Das auf der Leiterplatte 9 angeordnete feste Sensorelement 83 kann eine feste Elektrode ausbilden. Das Auslöseelement 81 bildet eine zur festen Elektrode bewegliche Gegenelektrode. Das Auslöseelement 81 kann mit Masse verbunden sein. Zwischen dem festen Sensorelement 83 und dem beweglichen Auslöseelement 81 wird ein elektrisches Feld erzeugt. Die Auswerteeinheit 10 ist ausgebildet, eine Änderung des elektrischen Felds zu erfassen, wenn sich das Auslöseelement 81 relativ zum Sensorelement 83 bewegt, wobei die Kapazität des Betätigungssensors 8 beeinflusst wird.

Die Auswerteeinheit 10 kann eine Änderung des elektrischen Felds und/oder die Kapazitätsänderung zuverlässig ermitteln. Der Analog-Digital-Wandler 50 ist eingerichtet, einen einen analogen Eingangssignal erzeugenden Betätigungshub H des Auslöseelements 81 und/oder des Betätigungselements 74 in einem Mikrometer-Bereich zu erfassen und in einen digitalen Ausgangssignal umzuwandeln. Das digitale Ausgangssignal des Analog-Digital-Wandlers 50 wird anschließend von dem Mikroprozessor 60 der Auswerteeinheit 10 weiterverarbeitet. Über den Mikroprozessor 60 kann das elektronische Schließsystem 80 betätigt werden.

In einer Weiterbildung kann der Mikroprozessor 60 mit weiteren so genannten Sendeempfangseinheiten 70, beispielweise so genannten Transceivern, gekoppelt sein. Die Sendeempfangseinheiten 70 können mit der Antenne 11, beispielsweise einer so genannten NFC-Antenne, zur Datenübertragen und/oder Kommunikation, und/oder mit fahrzeugseitigen Einheiten zur Datenübertragen und/oder Kommunikation verbunden sein.

### BEZUGSZEICHENLISTE

- 1: Fahrzeug
- 2: Tür
- 3: Heckklappe
- 4: Betätigungsmodul
- 5: Griffmodul
- 51: Türaußengriff
- 52: Türgriffabdeckung
- 53, 54: Oberfläche
- 6: Fahrzeugsäule
- 7: Betätigungseinheit
- 71 bis 73: Betätigungsfläche
- 74: Betätigungselement
- 75: Erfassungssensor
- 76: Innenraum
- 77: Oberfläche
- 720: Betätigungsfläche
- 740: Betätigungselement
- 8: Betätigungssensor
- 81: Auslöseelement
- 82: Abdeckelement
- 83: Sensorelement
- 9: Leiterplatte
- 10: Auswerteeinheit
- 11: Antenne
- 12: Verriegelungssensorfläche
- 13: Entriegelungssensorfläche
- 20: Komponente
- 30: Versiegelung
- 40: Vergussmaterial
- 50: Analog-Digital-Wandler
- 60: Mikroprozessor
- 70: Sendeempfangseinheit
- 80: Schließsystem
- H: Betätigungshub
- X: Längsrichtung
- Y: Querrichtung
- Z: Vertikalrichtung

## Patentansprüche

1. Betätigungsmodul (4) für ein elektronisches Schließsystem (80), umfassend zumindest:
- eine Betätigungseinheit (7) und
- einen in einem Innenraum (76) der Betätigungseinheit (7) angeordneten kapazitiven Betätigungssensor (8) zur Auslösung einer Schaltfunktion, insbesondere zum Entriegeln und Öffnen des elektronischen Schließsystems (80), und
- eine Auswerteeinheit (10),
wobei die Betätigungseinheit (7) zumindest eine in eine Außenumgebung gerichtete Betätigungsfläche (71 bis 73, 720) und ein nach innen gerichtetes Betätigungselement (74, 740) umfasst, das bewegungsfest mit der Betätigungsfläche (71 bis 73, 720) verbunden ist,
wobei die Betätigungsfläche (71 bis 73, 720) elastisch verformbar ist und bei einer Betätigung der Betätigungsfläche (71 bis 73, 720) in Richtung des Betätigungssensors (8) das Betätigungselement (74, 740) einen Betätigungshub (H) ausübt, wobei der Betätigungssensor (8) eingerichtet ist, den Betätigungshub (H) zumindest in einem Mikrometer-Bereich zu erfassen und ein Auslösesignal zur Auslösung der Schaltfunktion zu erzeugen,
**dadurch gekennzeichnet, dass**
die Auswerteeinheit (10) zumindest einen Analog-Digital-Wandler (50) und einen Mikroprozessor (60) umfasst, wobei der Analog-Digital-Wandler (50) zur Umwandlung einer erfassten Kapazitätsveränderung des Betätigungssensors (8) in Digitalwerte und der Mikroprozessor (60) zur Verarbeitung der Digitalwerte und zur Erzeugung des Auslösesignals vorgesehen ist, und der Analog-Digital-Wandler (50) mit dem Betätigungssensor (8) signaltechnisch verbunden und eingerichtet ist, den Betätigungshub (H) des Betätigungssensors (8) in einem Mikrometer-Bereich zu erfassen.

2. Betätigungsmodul (4) nach Anspruch 1, wobei der Betätigungssensor (8) zumindest ein im Innenraum (76) der Betätigungseinheit (7) fest angeordnetes Sensorelement (83) und ein relativ zum Sensorelement (83) bewegliches Auslöseelement (81) umfasst.

3. Betätigungsmodul (4) nach Anspruch 2, wobei das Auslöseelement (81) als ein elastisch verformbares Blech, insbesondere Federblech oder Metallblech, ausgebildet ist.

4. Betätigungsmodul (4) nach einem der vorhergehenden Ansprüche, wobei das Betätigungselement (74, 740) als Betätigungsstößel oder Betätigungspin oder Erhebung oder Nase ausgebildet ist.

5. Betätigungsmodul (4) nach einem der vorhergehenden Ansprüche, wobei das Betätigungselement (74, 740) bei Betätigung der Betätigungsfläche (71 bis 73, 720) den Betätigungshub (H) in Richtung des Auslöseelements (81) ausübt.

6. Betätigungsmodul (4) nach einem der vorhergehenden Ansprüche, wobei die Betätigungsfläche (71 bis 73, 720) innenseitig mit dem Betätigungselement (74, 740) versehen ist, welches bei Betätigung der Betätigungsfläche (71 bis 73, 720) mitbewegbar ist und punktuell in Eingriff mit dem Auslöseelement (81) des Betätigungssensors (8) gelangt und dieses flächig verformt, insbesondere biegt.

7. Betätigungsmodul (4) nach Anspruch 2 oder 3, wobei das Auslöseelement (81) mit einem aus Kunststoff gebildeten Abdeckelement (82) versehen ist.

8. Fahrzeugkomponente eines Fahrzeugs (1) mit einem Betätigungsmodul (4) nach einem der vorhergehenden Ansprüche 1 bis 7.

## Claims

1. Actuating module (4) for an electronic locking system (80), comprising at least:
- an actuating unit (7) and
- a capacitive actuating sensor (8), which is arranged in an interior (76) of the actuating unit (7), for triggering a switching function, in particular for unlocking and opening the electronic locking system (80), and
- an evaluation unit (10),
wherein the actuating unit (7) comprises at least one actuating surface (71 to 73, 720) directed into an external environment and an inwardly directed actuating element (74, 740) which is immovably connected to the actuating surface (71 to 73, 720), wherein the actuating surface (71 to 73, 720) is elastically deformable and, when the actuating surface (71 to 73, 720) is actuated in the direction of the actuating sensor (8), the actuating element (74, 740) exerts an actuating stroke (H), wherein
the actuating sensor (8) is designed to detect the actuating stroke (H) at least in a micrometre range and to generate a trigger signal for triggering the switching function,
**characterized in that** the evaluation unit (10) comprises at least an analogue-to-digital converter (50) and a microprocessor (60), wherein the analogue-to-digital converter (50) is provided for converting a detected change in capacitance of the actuating sensor (8) into digital values and the microprocessor (60) is provided for processing the digital values and for generating the trigger signal, and the analogue-to-digital converter (50) is connected in a signal-transmitting manner to the actuating sensor (8) and is designed to detect the actuating stroke (H) of the actuating sensor (8) in a micrometre range.

2. Actuating module (4) according to Claim 1, wherein the actuating sensor (8) comprises at least one sensor element (83) fixedly arranged in the interior (76) of the actuating unit (7) and a triggering element (81) movable relative to the sensor element (83).

3. Actuating module (4) according to Claim 2, wherein the triggering element (81) is in the form of an elastically deformable sheet, in particular spring sheet or metal sheet.

4. Actuating module (4) according to any of the preceding claims, wherein the actuating element (74, 740) is in the form of an actuating tappet or actuating pin or protuberance or lug.

5. Actuating module (4) according to any of the preceding claims, wherein the actuating element (74, 740) exerts the actuating stroke (H) in the direction of the triggering element (81) when the actuating surface (71 to 73, 720) is actuated.

6. Actuating module (4) according to any of the preceding claims, wherein the inner side of the actuating surface (71 to 73, 720) is provided with the actuating element (74, 740) which, when the actuating surface (71 to 73, 720) is actuated, is conjointly movable and comes into point-to-point engagement with the triggering element (81) of the actuating sensor (8) and deforms, in particular bends, the triggering element in a planar manner.

7. Actuating module (4) according to Claim 2 or 3, wherein the triggering element (81) is provided with a covering element (82) formed from plastic.

8. Vehicle component of a vehicle (1) having an actuating module (4) according to any of the preceding Claims 1 to 7.

## Revendications

1. Module d'actionnement (4) pour un système de fermeture électronique (80), comprenant au moins :
- une unité d'actionnement (7) et
- un capteur d'actionnement capacitif (8) disposé dans un espace intérieur (76) de l'unité d'actionnement (7) pour déclencher une fonction de commutation, en particulier pour déverrouiller et ouvrir le système de fermeture électronique (80), et
- une unité d'évaluation (10),
l'unité d'actionnement (7) comprenant au moins une surface d'actionnement (71 à 73, 720) dirigée vers l'environnement extérieur et un élément d'actionnement (74, 740) dirigé vers l'intérieur, qui est relié de manière solidaire en mouvement à la surface d'actionnement (71 à 73, 720),
la surface d'actionnement (71 à 73, 720) étant déformable élastiquement et, lors d'un actionnement de la surface d'actionnement (71 à 73, 720) en direction du capteur d'actionnement (8), l'élément d'actionnement (74, 740) exerçant une course d'actionnement (H),
le capteur d'actionnement (8) étant conçu pour détecter la course d'actionnement (H) au moins dans une plage de l'ordre du micromètre et générer un signal de déclenchement pour déclencher la fonction de commutation,
**caractérisé en ce que** l'unité d'évaluation (10) comprend au moins un convertisseur analogique-numérique (50) et un microprocesseur (60), le convertisseur analogique-numérique (50) étant prévu pour convertir une variation de capacité détectée du capteur d'actionnement (8) en valeurs numériques, et le microprocesseur (60) étant prévu pour traiter les valeurs numériques et générer le signal de déclenchement, le convertisseur analogique-numérique (50) étant relié au capteur d'actionnement (8) par échange de signaux et étant conçu pour détecter la course d'actionnement (H) du capteur d'actionnement (8) dans une plage de l'ordre du micromètre.

2. Module d'actionnement (4) selon la revendication 1, dans lequel le capteur d'actionnement (8) comprend au moins un élément capteur (83) disposé de manière fixe dans l'espace intérieur (76) de l'unité d'actionnement (7) et un élément de déclenchement (81) mobile par rapport à l'élément capteur (83).

3. Module d'actionnement (4) selon la revendication 2, **caractérisé en ce que** l'élément de déclenchement (81) est réalisé sous la forme d'une tôle déformable élastiquement, en particulier d'une tôle de ressort ou d'une tôle métallique.

4. Module d'actionnement (4) selon l'une quelconque des revendications précédentes, dans lequel l'élément d'actionnement (74, 740) est réalisé sous la forme d'un poussoir d'actionnement ou d'une tige d'actionnement ou d'une protubérance ou d'un ergot.

5. Module d'actionnement (4) selon l'une quelconque des revendications précédentes, dans lequel l'élément d'actionnement (74, 740) exerce la course d'actionnement (H) en direction de l'élément de déclenchement (81) lors de l'actionnement de la surface d'actionnement (71 à 73, 720).

6. Module d'actionnement (4) selon l'une quelconque des revendications précédentes, **caractérisé en ce que** la surface d'actionnement (71 à 73, 720) est pourvue intérieurement de l'élément d'actionnement (74, 740) lequel, lors de l'actionnement de la surface d'actionnement (71 à 73, 720), peut se déplacer conjointement et entre en contact ponctuel avec l'élément de déclenchement (81) du capteur d'actionnement (8), le déformant superficiellement, en particulier en le pliant.

7. Module d'actionnement (4) selon la revendication 2 ou 3, dans lequel l'élément de déclenchement (81) est muni d'un élément de recouvrement (82) en matière plastique.

8. Composant de véhicule d'un véhicule (1) comportant un module d'actionnement (4) selon l'une quelconque des revendications précédentes 1 à 7.
